# EUROPEAN PATENT APPLICATION

(11) **EP 1 542 263 A1**
(43) Date of publication of application: **15.06.2005**
(21) Application number: 03736284.5
(22) Date of filing: 26.06.2003
(51) Int. Cl.: H01L 21/027, G03F 7/20

(54) **ELECTRON BEAM EXPOSURE METHOD AND SYSTEM THEREFOR**

(30) Priority: 03.07.2002 JP 2002227945
(71) Applicant: Kabushiki Kaisha PD Service, Chofu-shi, Tokyo 182-0023 (JP)
(72) Inventor: HISATSUGU, Tokushige, Chofu-shi, Tokyo 182-0023 (JP)
(74) Representative: Leson, Thomas Johannes Alois, Dipl.-Ing.
(86) International application number: PCT/JP2003/008145
(87) International publication number: WO 2004/006307

(57) **Abstract**

A method of leading an electron beam (22) radiated from an electron emitter (14) through openings provided in a stencil mask (18) to a sensitive sample (12) and exposing it includes placing the electron beam under a low field intensity where the electron beam progresses at a slow speed until reaching the openings of the stencil mask and thereafter placing the electron beam having passed through the openings of the stencil mask under a high field intensity where the electron beam progresses at a high speed. An apparatus for electron beam projection lithography comprises an electron emitter, a stencil mask having openings for permitting the electron beam radiated from the electron emitter to pass through, a base (16) for supporting an exposure sample, and a device for placing the electron beam under a low field intensity as well as a high field generator for placing the electron beam under a high field intensity.

## Description

### Field of Art

The present invention relates to a method for electron beam projection lithography and an apparatus to be used therefor.

### Background Art

It is known, for transcribing a very fine geometric pattern such as a semiconductor integrated circuit on an electron exposure sample such as a silicon wafer, to use a mask (stencil mask) provided with a plurality of openings constituting the pattern and expose the pattern on the exposure sample by an electron beam passed through the openings of the stencil mask.

The stencil mask with the pattern formed is set as one with a very small thickness dimension so as to make its aspect ratio (the ratio of the width dimension to the depth dimension of an opening) appropriate. Such a thin stencil mask has a property to be poor in mechanical strength and heat-resisting strength.

When an electron beam passes the openings of the stencil mask or crosses the openings, a part thereof hits the opening edges or portions between the openings of the stencil mask. The stencil mask absorbs the electron beam hitting the mask and thermally deforms, which sometimes caused deformation in the pattern formed in the stencil mask, spoiling the accuracy in transcribing the pattern into the exposure sample.

Heretofore, in order to prevent such thermal deformation of a stencil mask, it has been proposed to pass an electron beam which is slow in travel speed, that is, of a low energy through openings of the stencil mask (Japanese Patent Appln. Public Disclosure (KOKAI) No. 11-135424 and No. 9-274884).

Japanese Patent Appln. Public Disclosure (KOKAI) No. 11-135424 discloses placing an electron beam radiated from an electron emitter, by applying a low voltage (2 KeV) to the electron emitter, under a low uniform motion and making the interval between a stencil mask and an exposure sample very small (50 µm).

According to this, heating of the stencil mask is suppressed by the electron beam progressing at a slow speed, that is, in a low-energy state. Also, because of a narrow space between the stencil mask and the exposure sample, lateral diffusion of the electron beam due to mutual repulsive action of electrons under slow speed traveling (accordingly, long traveling) of the electron beam is minimized, and a so-called out-of-focus pattern on the exposure sample due to the lateral diffusion is prevented. However, even according to this, resolution is insufficient.

Also, the electron beam, being under the low-energy state due to the slow speed, can only infiltrate into the surface layer of a resist of the exposure sample after passing the stencil mask. Therefore, the resist capable of forming the pattern is limited to a thin one (0.1 µm or less), and it is difficult to apply to a single-layer thick film resist (0.3 µm or over) which is practically required in a production process of a semiconductor. Further, because of a narrow space between the stencil mask and the exposure sample, use of an exposure sample with a coarse surface or an exposure sample having protrusion might damage the stencil mask.

On the other hand, Japanese Patent Appln. Public Disclosure (KOKAI) No. 9-274884 discloses placing an electron beam radiated from an electron emitter in a high accelerated state (acceleration by application of a voltage (50 keV) for high acceleration), and then, just before the stencil mask, placing it in a low accelerated state (reduction by application of a low acceleration voltage (5 keV)), and placing the electron beam after passing through the openings of the stencil mask again in a high accelerated state (acceleration by application of a high acceleration voltage (50 keV)).

According to this, by the reduction of the electron beam, a great heat load to the stencil mask is avoided, and by the re-acceleration of the electron beam having passed through the stencil mask, the arrival time of the electron beam at the exposure sample is shortened to avoid narrowing of the space between the exposure sample and the stencil mask, thereby enabling to transcribe on a single layer thick film resist.

The re-acceleration of the electron beam, however, does not contribute to preventing the electron beam from diffusing laterally due to the reduction immediately before, thereby obliging a so-called out-of-focus pattern to be generated.

### Disclosure of the Invention

It is an object of the present invention to provide a method of electron beam projection lithography which improves resolution of the exposure on an exposure sample without increasing a heat load to a stencil mask, and an apparatus therefor.

The method of electron beam projection lithography according to the present invention leads an electron beam radiated from an electron emitter through openings provided in a stencil mask to an exposure sample to expose it, and comprises placing the electron beam under a low electric field intensity for progressing at a slow speed until the electron beam reaches the openings of the stencil mask, and thereafter, placing the electron beam having passed through the openings of the stencil mask under a high electric field intensity where the electron beam progresses at a high speed.

Preferably, the low field intensity (V'₁), the high field intensity (V'₂), and a voltage (V) to be applied to the stencil mask for generating the high field intensity are determined to satisfy the relationship: (V'₁ - V'₂)/4V = 1/F (where F is a distance between the openings of the stencil mask and an convergent point of the electron beam having passed through the openings) so that the electron beam having passed through the openings of the stencil mask may converge.

The apparatus for electron beam projection lithography according to the present invention comprises: an electron emitter, a stencil mask having an openings which permit the electron beam radiated from the electron emitter to pass through; a base for supporting an exposure sample to be exposed upon receipt of the electron beam having passed through the openings of the stencil mask; a low field generator for placing the electron beam under a low field intensity so that the electron beam may progress at a slow speed until reaching the openings of the stencil mask; and a high field generator for placing the electron beam having passed through the openings of the stencil mask under a high field intensity where the electron beam progresses at a high speed.

The low field generator may include an electrode disposed on the upstream side of the stencil mask relative to the progressing direction of the electron beam and a power source connected to the electrode, and the high field generator may include a power source connected to the electrode, using the stencil mask as an electrode.

The apparatus for electron beam projection lithography can further comprise a second stencil mask disposed on the upstream side of the above-mentioned stencil mask in the progressing direction of the electron beam and having openings of the same or a larger size as or than the corresponding openings of the above-mentioned stencil mask.

In the exposure apparatus comprising the second stencil mask, the low field generator can further include a power source connected to the second stencil mask as an electrode.

The base for the exposure sample may be one provided with a support position changing mechanism for changing a position supporting the exposure sample and thereby to change the distance between the exposure sample and the stencil mask.

According to the present invention, the energy which the electron beam has can be maintained at a comparatively low level by placing the electron beam radiated from the electron emitter and introduced to an exposure sample through the openings of the stencil mask under the low field intensity (under low acceleration) where the electron beam progresses at a slow speed up to immediately before reaching the openings of the stencil mask, thereby suppressing a temperature rise of the stencil mask due to a part of the electron beam which is incident on the stencil mask, hitting the peripheral edge of the openings to be absorbed thereby, and its incidental thermal deformation. Also, by placing the electron beam having passed through the stencil mask under a high field intensity (under high acceleration) where the electron beam progresses at a high speed, the traveling time of the electron beam required until reaching the exposure sample is reduced, avoiding a lateral diffusion of the electron beam during this time, thereby preventing a so-called out-of-focus pattern in the exposure sample from generating, which enables to attain high resolution exposure.

Further, by preventing a lateral diffusion of the electron beam, the space between the exposure sample and the stencil mask can be set at a comparatively wide one, thereby enabling to reduce contamination of the stencil mask, that is, contamination by evaporation from the resist of the exposure sample accompanying the exposure as well as the number of cleaning times of the stencil mask, and to aim at reduction in breakage time of the stencil mask while cleaning and to aim at longevity of the stencil mask accompanying it. Further, it is possible to make an exposure sample with a comparatively coarse surface or an exposure sample with a curvature an object of exposure.

The low and the high fields where the electron beam is to be placed can be generated respectively by the low field generator and the high field generator in the electron beam exposure apparatus according to the present invention. The low field generator includes an electrode disposed on the upstream side of the stencil mask relative to the progressing direction of the electron beam and a power source connected to the electrode, while the high field generator includes a power source connected to the stencil mask as an electrode.

When fixing the low field intensity (V'₁), the high field intensity (V'₂), and the voltage (V) to be applied to the stencil mask for generating the high field intensity so as to satisfy (V₁ - V'₂)/4V = 1/F (where F is a distance between the openings of the stencil mask and the convergent point of the electron beam having passed through the openings), a so-called lens effect can be given to an electron passing through the openings. This enables to converge the electron beam against the exposure sample and to obtain a deep focal depth. As a result, the electron beam can be made to reach a deep portion of the comparatively thick resist which is often provided in the exposure sample, thereby enabling to transcribe an accurate fine pattern. Also, by this, it is possible to generate a gap enlarged by the resist of the exposure sample.

When supporting the exposure sample with the base having a support position changing mechanism, a relative distance of the exposure sample with respect to the stencil mask can be properly set in accordance with the surface configuration and the general configuration of the exposure sample. Also, by changing the distance or the space between the exposure sample and the stencil mask, the high field intensity (V'₂) can be changed without changing the applied voltage (V), thereby facilitating the field control for obtaining the lens effect.

In exposing the exposure sample to the electron beam, it is possible further to dispose a second stencil mask having corresponding openings larger than the openings of the above-mentioned stencil mask. Since the second stencil mask is disposed on the upstream side of the original stencil mask (pattern forming stencil mask) relative to the progressing direction of the electron beam, the electron beam radiated from the electron emitter, when passing through the openings of the second stencil mask and the openings of the mask for pattern formation successively, hits only the second stencil mask but does not hit the pattern forming stencil mask located on the downstream side thereof. Therefore, the thermal expansion of the first stencil mask is further reduced, so that more accurate fine pattern transcription can be realized.

Also, when providing the second stencil mask, by disposing a power source connected to the second stencil mask as an electrode, the electron beam moving at a slow speed can be one step further accelerated.

### Brief Description of the Drawings

Fig. 1 is a schematic drawing of the apparatus for electron beam projection lithography according to the present invention.
Fig. 2 is a graph showing the voltage applied to each electrode and a potential gradient (field intensity) between the electrodes in the apparatus shown in Fig. 1.
Fig. 3 is an explanatory drawing of the lens effect.
Fig. 4 is a schematic drawing similar to Fig. 1, showing another example of the apparatus for electron beam projection lithography according to the present invention.
Fig. 5 is a schematic drawing similar to Fig. 1, showing still another example of the apparatus for electron beam projection lithography according to the present invention.
Fig. 6 is a sectional view showing stratified two stencil masks.

### Best Mode for Carrying Out the Invention

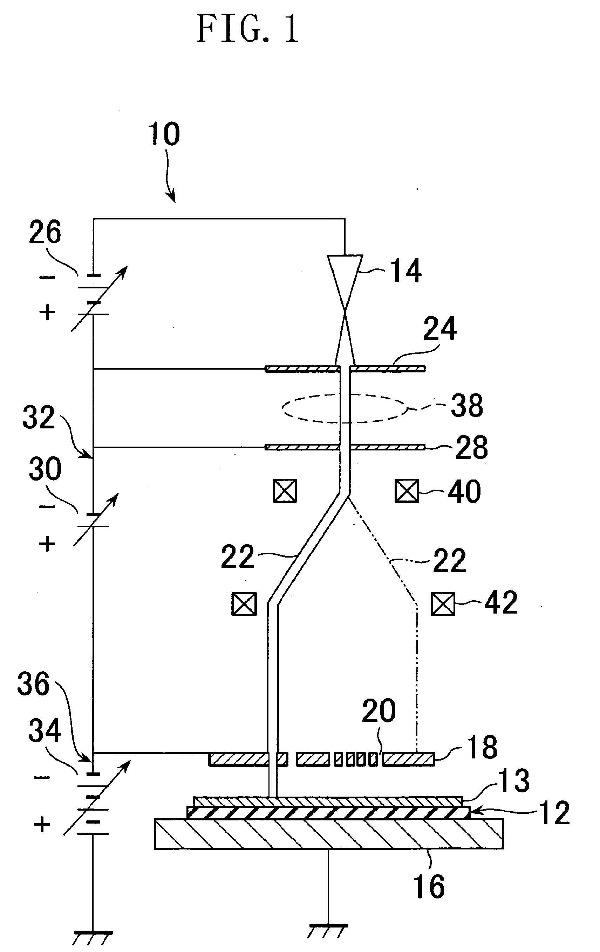

Referring to Fig. 1, an example of the apparatus for electron beam projection lithography according to the present invention is generally shown with a reference numeral 10.

The apparatus for electron beam projection lithography (hereinafter to be called "exposure apparatus") 10 is used to project and transcribe a fine geometrical pattern (hereinafter to be called "pattern") for forming, for example, a semiconductor integrated circuit on a resist 13 of an electron exposure sample (hereinafter to be called "exposure sample") such as a silicon wafer.

The exposure apparatus 10 provided for such a purpose comprises a radioactive source 14 such as an electron gun which projects the pattern on the resist 13 of the exposure sample and radiates an electron for exposing, a base 16 such as a stage for supporting the exposure sample 12 and also a plate-like stencil mask 18 in which the pattern to be projected is formed.

The radioactive source 14, the base 16 and the stencil mask 18 are disposed within a vacuum space defined by a column (not shown) which constitutes a part of the exposure apparatus 10. In more detail, the radioactive source 14 and the base 16 are disposed respectively in the uppermost position and the lowermost position of the column, and the stencil mask 18 is horizontally disposed at an interval from and above the base 16. Also, the exposure sample 12 is horizontally disposed on the base 16 in parallel to the stencil mask 18.

The stencil mask 18 is made of or from Si, SiC, SiN, diamond, diamond-like carbon, or the like. In the stencil mask 18, a plurality of openings (through holes) 20 are formed. These openings 20 define the pattern.

An electron beam 22 radiated from the radioactive source 14 is accelerated in a low intensity field and a high intensity field respectively formed in a space above and a space below the stencil mask 18. By this, the electron beam 22 progresses at a slow speed up to the openings 20 of the stencil mask under the low field intensity, progresses at a high speed under the high field intensity after passing through a part of the openings 20 of the stencil mask 18, reaches the resist 13 of the exposure sample, and exposes it.

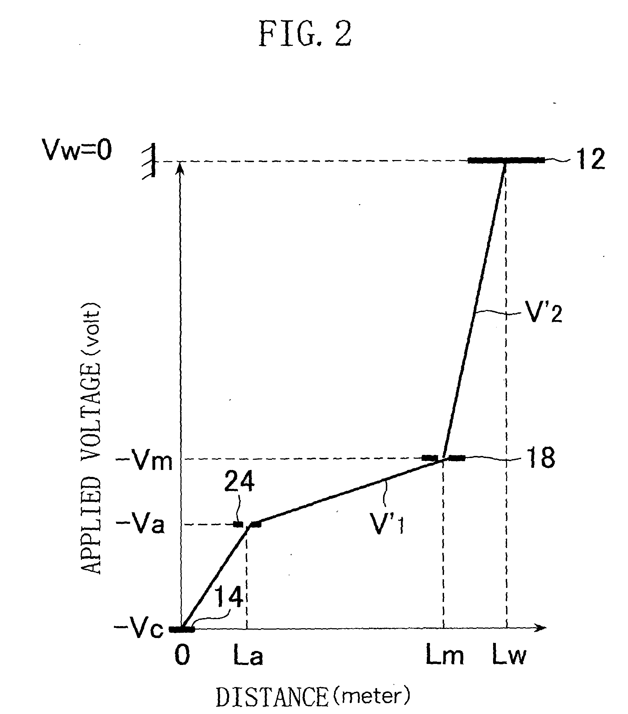

For radiation of the electron from a cathode 14 as the electron emitter, an electrode (anode) 24 is disposed immediately below the cathode 14, a dc power 26 is connected to both cathode 14 and anode 24, and voltages -Vc and - Va (Fig. 2) are respectively applied. As shown in Fig. 2, these voltages - Vc and - Va (- Vc < - Va) are respectively lower voltages than the voltage of the exposure sample 12 set at zero voltage (Vw = 0) by ground connection of the base 16.

Below the anode 24, a blanking electrode 28 is disposed. A dc power 30 is connected to this electrode 28 and the stencil mask 18 located therebelow, and the voltage is applied. In the anode 24 and the electrode 28, holes for passing the beam 22 of the electron radiated from the cathode 14 are provided.

The anode 24 as well as its power source 26, the electrode 28, the stencil mask 18 as an electrode, and a dc power 30 for them constitute a low field generator 32, and generate the low intensity field in the space above the stencil mask 18.

To the stencil mask 18 as an electrode, a ground-connected dc power 34 is connected to apply a voltage - Vm (- Vm > - Va). The stencil mask 18 and the dc power 34 constitute a high field generator 36 to generate the high intensity field in the space below the stencil mask 18.

According to this, the beam 22 of the electron radiated from the cathode 14 is accelerated between the cathode 14 and the anode 24 by the low field generator 32 and further accelerated between the anode 24 and the stencil mask 18, to progress at a slow speed.

Also, the electron beam 22 having passed through the stencil mask 18, being accelerated between the stencil mask 18 and the exposure sample 12 by the high field generator 36, progresses at a high speed.

In the exposure apparatus 10, in order to converge the electron beam 22 having passed the anode 24, there is disposed a converging coil 38 between the anode 24 and the electrode 28 therebelow.

In the exposure apparatus 10, further, a pair of upper and lower deflection coils 40, 42 are disposed so that the electron beam 22 can scan on the exposure sample 12 (in more detail, on the resist 13). According to this, the electron beam 22 is made to change its progressing direction by one (upper) of the deflection coils 40, and then passed through a predetermined opening 20 of the stencil mask 18 by the other (lower) deflection coil 42 to determine its progressing direction so as to be incident perpendicularly on the surface of the exposure sample 12.

Exposure of a single layer resist, for example, in a production process of a semiconductor can be set at about 10 kV (absolute value) required therefor. For this reason, the total voltage of the power sources 26, 30 and 34 can be set at - 10 kV, and the total voltage of the sources 26 and 30 and the voltage of the source 34 can be set respectively at - 4 kV and - 6 kV

According to the present invention, since the electron beam 22 progresses at a slow speed under the low field intensity, the energy level is comparatively low; therefore, the degree of heat generation caused in the stencil mask 18 due to incidence of the electron beam 22 is comparatively low, so that a thermal load to the stencil mask 18 can be reduced. Also, it is easy for a converging coil for beam formation (not shown) sometimes used as a part of the exposure apparatus 10 or a deflection coils 30, 32 to display its performance.

Also, the electron beam 22 under the high field intensity directly progresses accurately, without shifting its position, toward a predetermined position on the exposure sample 12, so that exposure of a higher resolution as regards the exposure sample can be obtained.

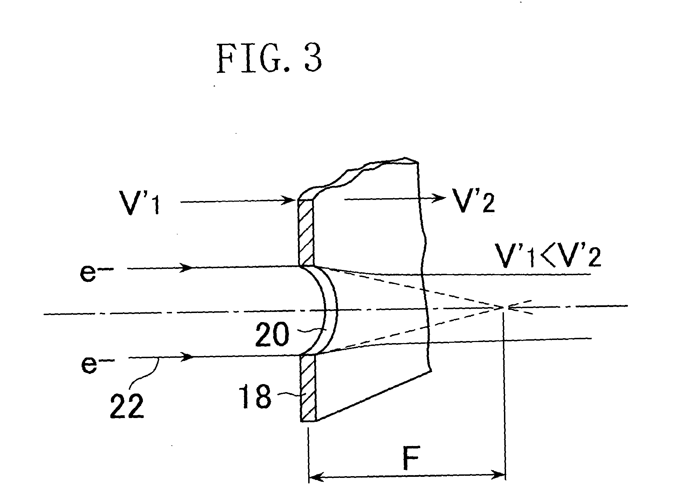

Fig. 3 is referred to in the following:

A so-called lens effect which is an effect of convergence of the electron beam 22 having passed through the openings 20 of the stencil mask can be obtained by setting the low field intensity (V'₁), the high field intensity (V'₂), and the potential - Vm of the stencil mask 18 as an electrode so as to satisfy the relationship among them (V'₂ - V'₁)/4 Vm = 1/F.

Here, F shows a distance (focal length) between the openings 20 of the stencil mask and the convergent point of the electron beam 22. Also, the low field intensity V'1 = {- Vm - (- Va)}/(Lm - La), and the high field inensity V'2 = {- Vw - (- Vm)}/(Lw - Lm). Here, La, Lm and Lw are respectively a distance from the cathode 14 to the anode 24, a distance from the cathode 14 to the stencil mask 18, and a distance from the cathode 14 to the exposure sample 12, and their unit is meter (see Fig. 2). Also, the unit of Va, Vm and Vw is volt.

By the convergence of the electron beam 22 due to the lens effect, it is possible to make the electron beam 22 reach and expose the deep part of the resist 13 of the exposure sample and, thereby, transcribe the pattern more accurately.

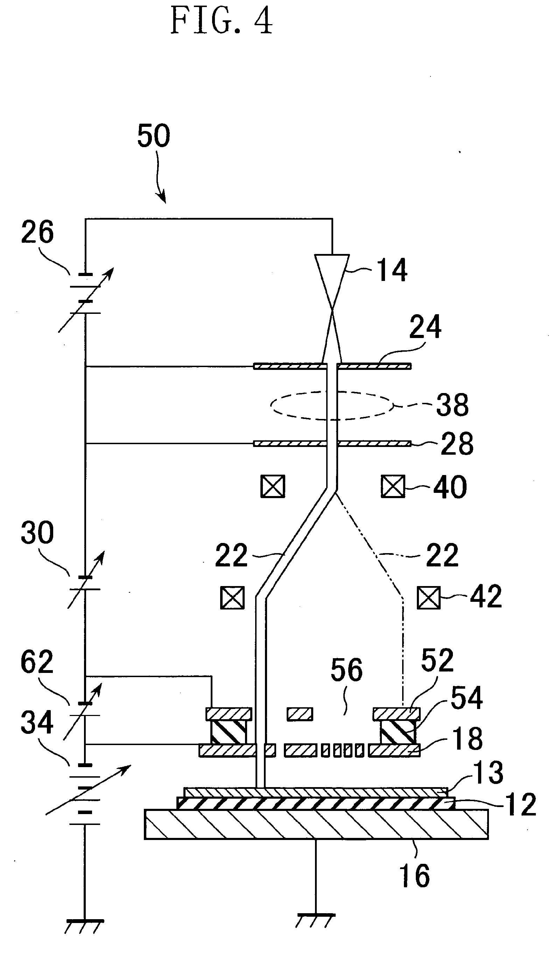

Fig. 4 showing another embodiment of the present invention is referred to in the following.

The exposure apparatus 50 relative to this embodiment is different from the exposure apparatus 10 shown in Fig. 1 in comprising a second stencil mask 52 besides the stencil mask 18.

The second stencil mask 52 is mde of or from Si, SiC, SiN, diamond, diamond-like carbon, tungsten, molybdenum, etc., and its thickness dimension can be chosen arbitrarily. The second stencil mask 52 is disposed on the upstream side of the stencil mask (in order to distinguish from "the second stencil mask 52," sometimes called "pattern forming stencil mask") 18. In more detail, the second stencil mask 52 is disposed at an interval above the pattern forming stencil mask 18 in parallel thereto, constituting an assembly integrated with the pattern forming stencil mask 18 through a frame 54 including an insulator such as a glass plate disposed between both stencil masks 18 and 52.

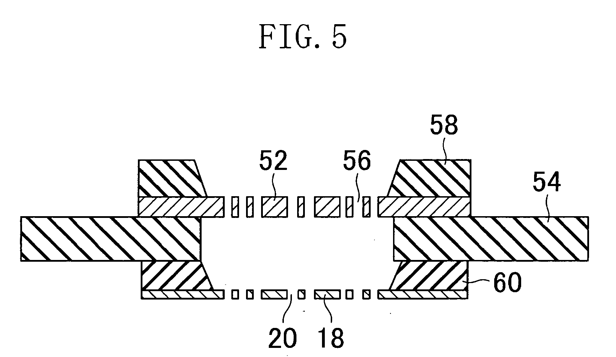

The second stencil mask 52 has a plurality of openings 56 confronting the plural openings 20 of the pattern forming stencil mask 18. In the illustration, the openings 56 are set to be larger than the openings 20, but as shown in Fig. 5, it is possible to set to have the same size and the same shape as the openings 20.

As shown in Fig. 5, both stencil masks 52 and 18 are formed by providing openings 56 and 20 in a SiN film deposited on the undersides of silicon base plates 58, 60. Both silicon base plates 58, 60 have holes 59, 61 respectively surrounding the openings 56, 20, and reinforce both stencil masks 52, 18. The stencil mask 52 and the silicon base plate 60 are adhered respectively to the upside and underside of the frame 54.

By disposing the second stencil mask 52 above the pattern forming stencil mask 18, the second stencil mask 52 receives a part of the useless electron beam 22 which the pattern forming stencil mask 18 should normally receive, thereby reducing thermal deformation of the pattern forming stencil mask 18.

In this embodiment, further, there is provided a dc power 62 which makes the second stencil mask 52 and the pattern forming stencil mask 18 respectively a negative electrode and a positive electrode.

According to this, it is possible to change the magnitude of the low field intensity V'1 by applying voltages to both stencil masks 52, 18, without changing the voltage of the power source 30, and thereby, the focal distance (focal depth) F in the lens effect can be readily changed and controlled according to the thickness of the resist 13 of the exposure sample.

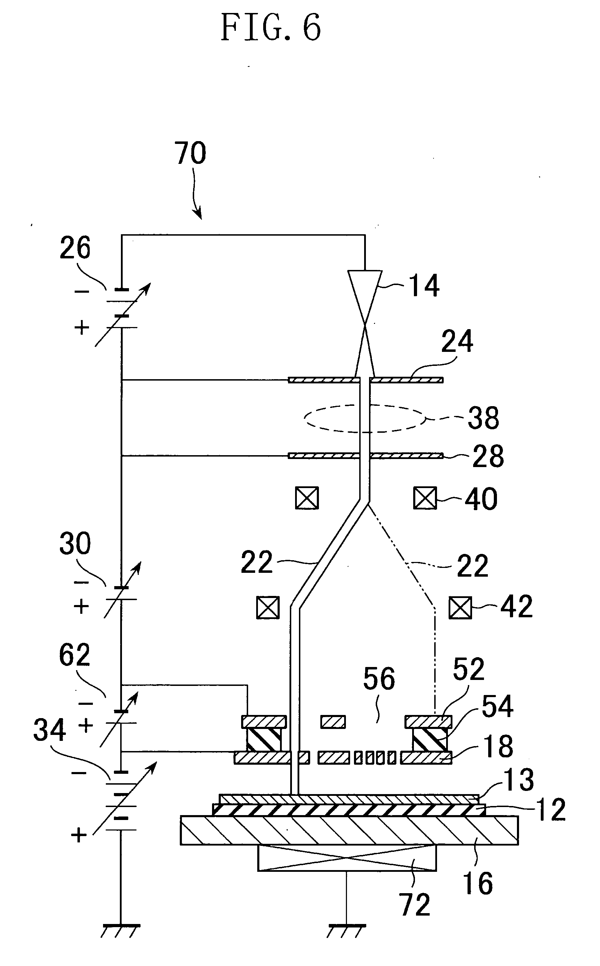

Fig. 6 showing still another embodiment of the present invention is referred to in the following.

An exposure apparatus 70 according to this embodiment is further different from the exposure apparatus 50 shown in Fig. 4 in that the base 16 of the exposure sample 12 has a support position changing mechanism 72 for the exposure sample 12.

The support position changing mechanism 72 includes an arbitrary structure capable of moving the base 16 upward and downward, and by operating the support position changing mechanism 72, capable of changing the height positions of the base 16 and the exposure sample 12 thereon by ascending and descending them, thereby arbitrarily changing the distance between he exposure sample 12 and stencil mask 18.

According to this, the distance (Lw - Lm) can be changed without changing the value of the applied voltage - Vm, and by this, the high field intensity V'1 can be changed. As a result, the focal distance F in the lens effect according to the thickness of the resist 13 of the exposure sample can be readily changed and controlled.

Also, a space necessary for disposing an exposure sample with a coarse surface, an exposure sample with a curvature and the like can be easily obtained between the exposure sample and the the stencil mask 18.

The support position changing mechanism 72 can be also applied to the exposure apparatus 10 shown in Fig. 1.

As mentioned above, in the exposure apparatus 10, 50, 70 of the present invention, a voltage required for each electrode (cathode 14, anode 24, stencil mask 18, exposure sample 12, etc.) relative to addition of the irradiation energy to the electron beam 22 from the generation of the electron beam 22 to its reshaping, deviation, incidence on the masks 18, 52 for pattern transcription or the like, the arrival up to the exposure sample 12 is divided and applied.

Usually, as mentioned above, the voltage of the exposure sample 12 is made zero in ground connection, the maximum voltage value (negative polarity) required for the cathode 14 is added, a low voltage (negative polarity) is applied to the anode 24 and the stencil mask 18 successively, and the irradiation electron beam is made to reach the exposure sample 12. While this enables to avoid a breakdown of the electronic circuit and the like formed inside the exposure sample 12, by maintaining the exposure sample 12 at an earth potential (zero potential), it requires a power source for generating the maximum voltage value.

Also, if, in terms of the radiation of the electron beam 22, its reshaping and its deviation, the relative voltage value between the electrodes relating to them does not change, it sometimes happens that the relation of a housing of the above-mentioned apparatus which has the earth potential to the field changes and influences the characteristics of the radiation, reshaping and deviation of electron. To prevent this, it is desirable to apply a field shield which causes each electrode no change in the field relative to the earth potential.

Also, with respect to an exposure sample (e.g., an exposure resist presented for evaluation of an irradiation characteristic of the exposure resist) which dos not need to take a breakdown into account, it is possible to use a power source which is low in the maximum value of the required power voltage (dispersion of portions with a high-voltage applied).

Further, it is possible to keep each electrode potential of regions relating to the radiation, reshaping and deviation of the electron beam 22 constant, to fix the characteristics of the radiation, reshaping and deviation of the electron beam 22, and to add, between the stencil mask 18 and the exposure sample 12, the remaining energy required for the electron beam 22 which has passed these regions, in a region for accelerating the electron beam 22. This is because it is easier taking measures to counter voltage variable in the region for performing only acceleration than taking measures to counter when the voltage varies in the region where the electron beam 22 is radiated, reshaped and deviated. By setting the interval between the stencil mask 18 and the exposure sample 12 parallel to each other to be narrow and the interval between the housing and the exposure sample 12, respectively in the earth potential, to be wide, the influence due to a change in the field diffusion when the voltage increases can be reduced. At this time, a straight polarity voltage is preferably applied to the exposure sample.

Another example of the voltage values to be applied respectively to the cathode 14/anode 24/stencil mask 18/exposure sample 12 in case when the acceleration voltage is 6 kV of the irradiation electron beam is shown in the following.
(1) - 4 kV/- 2 kV/ - 2 kV/ + 2 kV (an example of setting the earth potential halfway between the stencil mask 18 and the exposure sample 12)
(2) - 2 kV/- 0 kV/ - 0 kV/ + 4 kV (an example of setting the anode 24 and the stencil mask 18 in the earth potential and setting the exposure sample 12 in a positive potential)

In either example, it is possible to choose an arbitrary voltage value between the voltage value applied to the cathode 14 and the voltage value applied to the exposure sample 12. In example (2), on account of the constitution of the apparatus, the cost can be reduced to the least in realizing the characteristics of the radiation of the electron beam 22, its reshaping and deviation, and stability in the characteristics can be obtained. Further, by changing positions for setting the earth potential, the radiation of the electron beam 22, its reshaping and the characteristics of its deviation are stabilized, thereby enabling to ensure the stability of the constitution and characteristics of the apparatus for changing the energy applied to the electron beam 22.

The exposure method and exposure apparatus according to the present invention can be also applied not only to the wafer and exposure of the exposure resist but also to production of the mask, production of MEMS (micro electro mechanical system) and the like.

## Claims

1. A method of electron beam projection lithography for leading and exposing an electron beam radiated from an electron emitter through openings provided in a stencil mask to an exposure sample, wherein said electron beam is placed under a low field intensity where the electron beam progressed at a slow speed until reaching the openings of said stencil mask, and wherein, thereafter, the electron beam having passed through the openings of said stencil mask is placed under a high field intensity where the electron beam progresses at a high speed.

2. A method according to claim 1, wherein said low field intensity (V'1), said high field intensity (V'2), and a voltage (V) applied to said stencil mask for generating said high field intensity are determined so as to satisfy a relationship (V'1- V'2)/4V = 1/F (where F is a distance between the openings of said stencil mask and a convergent point of said electron beam having passed through said openings), so that said electron beam having passed through the openings of said stencil mask may converge.

3. An apparatus for electron beam projection lithography comprising:
an electron emitter;
a stencil mask having openings for permitting an electron beam radiated from said electron emitter to pass through;
a base for supporting an exposure sample to be exposed upon receipt of the electron beam having passed through the openings of said stencil mask;
a low field generator for placing said electron beam under a low field intensity so that said electron beam may progress at a slow speed until reaching the openings of said stencil mask; and
a high field generator for placing said electron beam having passed through the openings of said stencil mask under a high field intensity where said electron beam progresses at a high speed.

4. An apparatus according to claim 3, wherein said low field generator includes an electrode disposed on the upstream side of said stencil mask relative to the progressing direction of said electron beam and a power source connected to said electrode; and wherein said high field generator includes a power source connected to said stencil mask as an electrode.

5. An apparatus according to claim 3, further comprising a second stencil mask disposed on the upstream side of said stencil mask relative to the moving direction of said electron beam and having openings larger than the corresponding openings of said stencil mask.

6. An apparatus according to claim 4, further comprising a second stencil mask disposed on the upstream side of said stencil mask relative to the moving direction of said electron beam and having openings larger than the corresponding openings of said stencil mask, wherein said low field generator further includes a power source connected to said second stencil mask as an electrode.

7. An apparatus according to claim 3, wherein said base for the exposure sample has a support position changing mechanism for changing positions to support said exposure sample to thereby change the distance between said exposure sample and said stencil mask.

8. An apparatus according to claim 5, wherein said base for the exposure sample has a support position changing mechanism for changing positions to support said exposure sample to thereby change the distance between said exposure sample and said stencil mask.
